# FASCICULE DE BREVET EUROPEEN

(11) **EP 0 901 227 B1**
(45) Date de publication et mention de la délivrance du brevet: **21.01.2004**
(21) Numéro de dépôt: 98402152.7
(22) Date de dépôt: 31.08.1998
(51) Int. Cl.: H03K 5/13

(54) **Circuit à retard variable**
Schaltung mit variabler Verzögerung
Variable delay circuit

(30) Priorité: 04.09.1997 FR 9711022
(43) Date de publication de la demande: 10.03.1999
(73) Titulaire: STMicroelectronics S.A., 92120 Montrouge (FR)
(72) Inventeur: Marbot, Roland, 75116 Paris (FR)
(74) Mandataire: Ballot, Paul

(56) Documents cités:
- EP-A- 0 317 758
- EP-A- 0 562 904
- EP-A- 0 606 979
- US-A- 5 327 031

## Description

L'invention concerne des circuits à retard variable, le retard étant réglable en fonction d'une consigne de retard. La consigne de retard peut prendre la forme d'une grandeur numérique.

Les applications des circuits à retard variable sont nombreuses. Ces circuits à retard sont par exemple utilisés pour des ajustements de phase entre deux signaux logiques. Dans ce cas, un des deux signaux est appliqué à l'entrée d'un circuit à retard. Le réglage du retard du circuit à retard est alors commandé par la mesure du déphasage à compenser entre ces deux signaux logiques.

Un asservissement de phase peut être réalisé au moyen d'un signal de réglage analogique ou numérique. La solution numérique est souvent préférée car elle est moins sensible aux perturbations et aux atténuations dues à la transmission des signaux. De plus, dans le cas d'une réalisation sous forme de circuit intégré, elle est moins sensible aux dispersions de fabrication.

Une première solution connue pour réaliser un circuit à retard à commande numérique consiste à utiliser un ensemble de portes élémentaires. Par exemple du type inverseur. L'ensemble des portes est associé à un système d'interconnexion, commandé numériquement, et permettant le branchement en cascade d'un nombre variable de portes élémentaires. L'application de ce type de circuit est cependant limitée aux cas où il n'est pas nécessaire d'obtenir une précision de réglage du retard inférieure au retard intrinsèque de la porte élémentaire.

Une autre solution connue consiste à utiliser un circuit du type résistance-capacité où la résistance est constituée de plusieurs résistances élémentaires, branchées sélectivement en parallèle en fonction de la commande numérique. Dans ce cas, le retard est fixé par la constante de temps du circuit. Si toutes les résistances élémentaires ont la même valeur, le retard obtenu est alors inversement proportionnel au nombre de résistances sélectionnées. Or, pour obtenir une précision de réglage constante sur toute la plage de réglage, il est nécessaire que la fonction liant le retard à la grandeur numérique de réglage s'approche le plus possible d'une fonction linéaire.

La réponse obtenue par la solution précédente est donc très éloignée de la relation linéaire puisqu'elle est de type hyperbolique. Pour se rapprocher de la réponse linéaire, il est alors nécessaire de dimensionner les résistances élémentaires à des valeurs bien précises et toutes différentes entre elles. Ce résultat est cependant très difficile à obtenir dans le cas d'une réalisation intégrée. D'autre part, il faudrait prévoir un tel circuit pour chaque signal que l'on veut ajuster en phase.

Si par exemple le circuit de retard est destiné à être utilisé dans un circuit verrouillé en phase du type décrit dans la demande de brevet européen publiée sous le numéro 0 441 684, déposée le 30 janvier 1991 et intitulé "Circuit verrouillé en phase et multiplieur de fréquence en résultant", la solution précédente n'est pas satisfaisante à cause de son encombrement et de sa sensibilité aux dispersions de fabrication.

L'invention a pour but de proposer un circuit à retard permettant un réglage précis, tout en assurant avec une approximation suffisante une réponse linéaire du retard en fonction de la consigne de retard, sur un intervalle de temps important, afin de s'approcher d'une précision de réglage constante.

Le brevet français publié sous le numéro 2 690 022 intitulé "Circuit à retard variable" présente un circuit à retard variable assurant une réponse linéaire du retard en fonction de la consigne de retard. Mais l'amplitude de la plage de retard qu'il procure n'est plus technologiquement satisfaisante.

En réponse à ce problème, un autre brevet publié en France sous le numéro 2 689 339 intitulé "Procédé et dispositif de réglage de retard à plusieurs gammes" couvre le concept de multi-plages. Cependant, des problèmes de linéarité du retard en fonction de la consigne de retard sont observés dans la pratique.

Le circuit de ce brevet a pour objet un circuit à retard pour fournir un signal de sortie présentant un retard par rapport à un signal d'entrée. Le retard est réglable en fonction d'une consigne de retard. Le circuit à retard comporte un circuit primaire, un circuit de combinaison et un circuit de mise en forme. Le circuit primaire reçoit le signal d'entrée et fournit deux signaux intermédiaires présentant entre eux un retard fixe. Le circuit de combinaison a deux entrées et comporte une entrée de commande recevant une grandeur de commande représentative de la consigne.

Les signaux intermédiaires sont appliqués aux deux entrées du circuit de combinaison. Le circuit de combinaison fournit en sortie un signal de combinaison résultant d'une superposition avec une pondération et un effet d'intégration des signaux intermédiaires appliqués sur ses entrées. La pondération consiste à pondérer par un coefficient de pondération chacun des signaux en entrée du circuit de combinaison. Les valeurs des coefficients de pondération sont fonction de la grandeur de commande.

Le signal de combinaison fourni par le circuit de combinaison est appliqué à l'entrée du circuit de mise en forme. Le circuit de mise en forme présente un effet de seuil. Le circuit de mise en forme produit un signal de déclenchement, le signal de sortie, lorsque le signal de combinaison, par effet d'intégration, atteint un seuil déterminé.

Ainsi, le retard effectif du signal de sortie par rapport au signal d'entrée est dépendant du niveau du signal de combinaison. Il est souhaitable que les amplitudes maximum et minimum du signal de combinaison soient indépendantes de la consigne de retard. Dans ce but, la somme des deux coefficients de pondération est constante.

En pratique, l'intégration dans le circuit de combinaison est produite par un intégrateur ou un circuit à constante de temps présentant toujours un effet de saturation définissant les niveaux extrêmes du signal de combinaison.

Un temps de transition est défini comme l'intervalle de temps pendant lequel le signal de combinaison varie selon une fonction linéaire ou quasi-linéaire lorsqu'un des coefficients de pondération associés aux signaux intermédiaires est nul.

Le fait d'imposer un retard fixe inférieur au temps de transition assure que le retard du signal de sortie par rapport au signal d'entrée ne présente pas de discontinuité en fonction des coefficients de pondération. Pour que la variation du retard en fonction de la consigne de retard varie sur toute la plage de réglage selon une fonction pratiquement linéaire de la consigne, le circuit de combinaison et/ou le circuit primaire à retard fixe pourront être dimensionnés de façon à ce que le retard fixe soit égal à la moitié du temps de transition.

C'est cette contrainte liant le retard fixe et le temps de transition qui empêche d'élargir l'amplitude de la plage de retard à partir du circuit décrit dans le brevet 2 690 022 mentionné ci-dessus. En effet, la plage de retard est définie par le circuit à retard fixe. Or si on augmente ce retard fixe, on ne répond plus à la condition imposant un retard fixe égal à la moitié du temps de transition. Cette condition assure la linéarité du retard du signal de sortie par rapport à la consigne d'entrée. Pour résoudre ce problème, dans le brevet 2 689 339, on modifie le circuit primaire. On y réalise un jeu de circuit de retards en cascade. On connecte les sorties de ces circuits de retard en cascade à un multiplexeur. Avec le multiplexeur on sélectionne, à titre de signaux intermédiaires, des couples de signaux possédant entre eux un retard fixe (comme avant) et, ensemble, un retard de base par rapport au signal d'entrée. Dans ce cas, au moment du saut de gamme, on constate des discontinuités technologiques de retard. Si la discontinuité est négative, elle engendre une impossibilité pour l'asservissement de trouver un réglage équilibré à une valeur acceptable. Dans l'invention, on remédie à ce problème en modifiant le circuit de combinaison de façon, en pratique, à ce qu'il ne permette pas d'explorer toute une plage.

L'invention a donc pour objet un circuit à retard pour fournir un signal de sortie présentant un retard par rapport à un signal d'entrée, le retard étant réglable en fonction d'une consigne de retard, le circuit à retard comportant
- un circuit primaire, recevant le signal d'entrée et fournissant des premier et second signaux intermédiaires présentant entre eux un retard fixe,
- un circuit de combinaison à deux entrées, fournissant en sortie un signal de combinaison résultant d'une superposition avec une pondération fonction de la grandeur de commande et un effet d'intégration des signaux appliqués sur ses entrées, les signaux intermédiaires étant appliqués aux deux entrées du circuit de combinaison,
- un circuit de mise en forme recevant le signal de combinaison, fournissant le signal de sortie, et présentant un effet de seuil,
le circuit de combinaison comportant
- une entrée de commande recevant une grandeur de commande représentative de la consigne,
- une ligne commune avec un condensateur relié à cette ligne commune et à un potentiel d'alimentation,
- un premier et un second module de charge et décharge de la ligne commune commandés respectivement par les premier et second signaux intermédiaires, le potentiel de la ligne commune constituant la mesure du signal de combinaison,
le circuit à retard étant caractérisé en ce que chaque module comporte un circuit de décharge et un circuit de charge comportant chacun des moyens interrupteurs contrôlant la connexion entre la ligne commune et respectivement un premier et un second potentiel d'alimentation d'une part par l'intermédiaire d'une résistance variable, d'autre part par une résistance non variable assurant la participation permanente des deux modules à la charge ou la décharge du condensateur et en ce que les moyens interrupteurs du circuit de décharge et du circuit de charge de chaque module sont activés par les signaux intermédiaires.

L'invention a également pour objet un mode de réalisation spécialement conçu pour pouvoir utiliser la technologie CMOS. Cette réalisation, ainsi que d'autres aspects et avantages de l'invention, apparaîtront dans la suite de la description en références aux figures, qui ne sont données qu'à titre indicatif et nullement limitatif de l'invention. Les figures montrent:
- la figure 1 représente le schéma de principe d'un circuit à retard variable à plusieurs plages de retard;
- les figures 2a à 2c, 4a à 4c, 6a à 6c et 8a à 8c présentent des chronogrammes permettant d'expliquer le fonctionnement du circuit de la figure 1;
- les figures 3, 5, 7, 9 montrent les variations du retard en fonction de la grandeur de commande pour différents dimensionnements du circuit de la figure 1;
- la figure 10 représente le schéma de principe d'une réalisation CMOS d'un circuit à retard variable à plusieurs plages de retard;
- la figure 11 représente une réalisation détaillée en technologie CMOS du circuit à retard variable à plusieurs plages de retard;
- la figure 12 présente une courbe théorique représentant des temps de retard en fonction de la commande numérique;
- la figure 13 montre une courbe représentant les temps de retard effectivement observés dans le circuit à retard variable à plusieurs plages de retard en fonction de la commande numérique;
- la figure 14 représente l'amélioration amenée par l'invention du circuit présenté à la figure 10 conduisant à une amélioration de la linéarité du retard en fonction de la commande numérique;
- la figure 15 représente l'amélioration amenée par l'invention du circuit présenté à la figure 11 conduisant à une amélioration de la linéarité du retard en fonction de la commande numérique;
- la figure 16 présente une comparaison, sur une plage, des temps de retard obtenus en fonction de la commande numérique, avec les circuits des figures 11 et 15;
- la figure 17 présente une comparaison entre des temps de retard obtenus avec le circuit de la figure 11 et ceux obtenus avec le circuit de la figure 15.

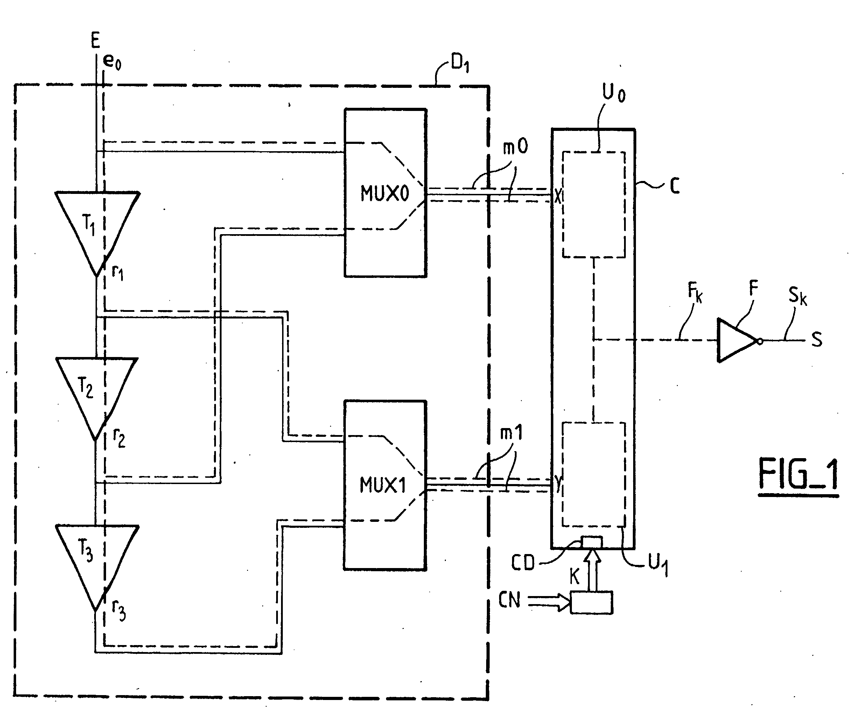

Un circuit de retard est représenté schématiquement à la figure 1. Il comporte un circuit primaire D1 à retard fixe. Le circuit D1 reçoit le signal d'entrée e0 et fournit en sortie des premier et deuxième signaux intermédiaire m0 et m1.

Les signaux m0 et m1 présentent entre eux un retard fixe T. Les signaux m0 et m1 sont appliqués respectivement aux entrées X et Y d'un circuit de combinaison C fournissant en sortie un signal de combinaison f_{K}. Le circuit de combinaison C comporte une entrée de commande CD recevant une commande K représentative des coefficients de pondération de la combinaison effectuée par le circuit C. Cette commande K est fonction d'une consigne de retard CN.

Le signal de combinaison f_{K} est appliqué à l'entrée d'un circuit de mise en forme F dont la sortie fournit le signal de sortie s_{K}. Pour simplifier la suite de l'exposé, on raisonnera sur les grandeurs normalisées des signaux impliqués et on supposera que les coefficients de pondération affectés aux signaux m0 et m1 sont respectivement les valeurs K et 1 - K, avec K compris entre 0 et 1.

Dans ces conditions, le circuit C est conçu pour réaliser la combinaison g_{K} = K.m0 + (1 - K).m1 avec intégration par rapport au temps pour obtenir f_{K} à partir de g_{K}.

Le signal e0 arrive à l'entrée E du circuit sur une première mémoire tampon (buffer dans la littérature anglaise) T1. Dans l'exemple préféré représenté, trois mémoires tampons identiques T1, T2 et T3 sont montés en série. Elles servent à introduire en série des retards fixes au signal e0. De préférence les retards fixes sont tous égaux entre eux à T de sorte que le signal e0 soit retardé de T, 2T, 3T, etc... Mais les retards pourraient être différents les uns des autres. On trouve le signal r1 à la sortie de la mémoire tampon T1, le signal r2 à la sortie de la mémoire tampon T2, le signal r3 à la sortie de la mémoire tampon T3. L'entrée de la première mémoire tampon est connectée à l'une des deux entrées d'un premier multiplexeur MUX0. La sortie de la mémoire tampon T2 constitue l'autre entrée du multiplexeur MUX0. Les sorties des mémoires tampons T1 et T3 sont connectées aux deux entrées d'un second multiplexeur MUX1. Les sorties des multiplexeurs MUX0 et MUX1 sont connectées aux entrées du circuit de combinaison C réalisant une interpolation de retard. La sortie du circuit de combinaison conduit le signal f_{K} au circuit de mise en forme F. Le circuit de combinaison est constitué de deux modules U0 et U1. L'interpolation peut ainsi être réalisée entre soit les signaux e0 et r1, soit les signaux r2 et r1, soit les signaux r2 et r3. Ces trois combinaisons sont les seules à présenter un retard constant égal à T entre les signaux. En présentant les signaux de ces trois combinaisons de signaux à l'entrée du circuit de combinaison, on est certain d'obtenir une plage de retard constante. La combinaison des signaux e0 et r3 ne sera jamais appliquée à l'entrée du circuit de combinaison, car le retard entre les deux signaux serait trop important et ne satisferait pas aux conditions de linéarité évoquées précédemment.

On peut ainsi mettre à la suite plusieurs plages de retard. La mise à la suite consiste à utiliser une première combinaison e0 r1 pour produire un retard variable entre 0 et T, à utiliser une deuxième combinaison r1 r2 pour produire un retard variable entre T et 2T, à utiliser une troisième combinaison r2 r3 pour produire un retard variable entre 2T et 3T et ainsi de suite, le nombre de mémoires tampons utilisées et la capacité des multiplexeurs conditionnant la dynamique totale de retard des circuits de retard de l'invention.

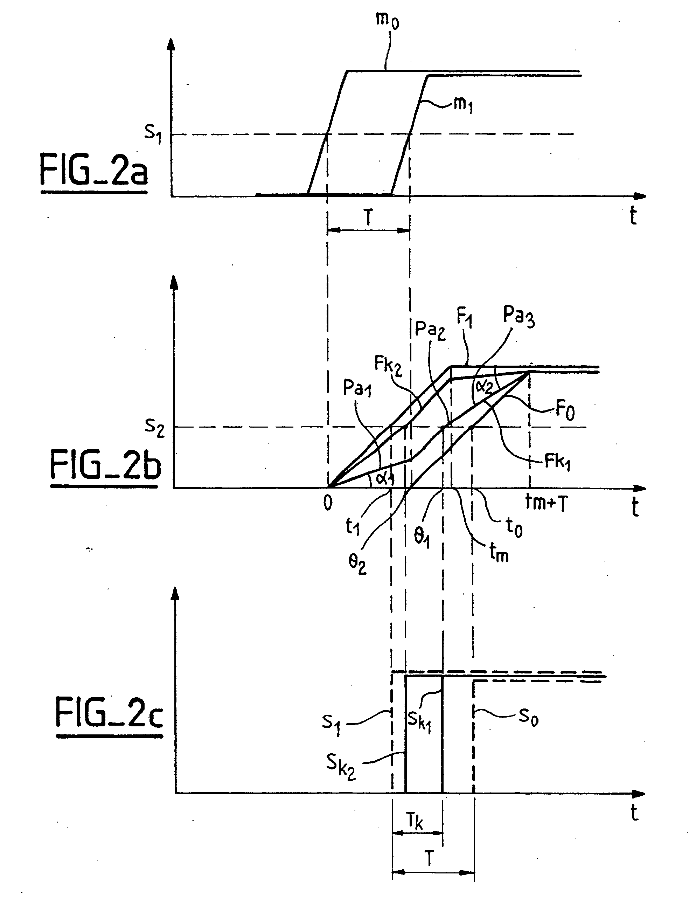

Les courbes présentés aux figures 2 à 9 permettent d'expliquer le fonctionnement du circuit de la figure 1. Elles explicitent les raisons qui ont empêché d'introduire un circuit D1 simple à retard fixe égal à un temps T' supérieur à T qui aurait directement agrandi la plage de retard. Elles exposent d'une part la nature des signaux de combinaison f_{K} et des signaux de sortie s_{K} selon la comparaison entre le temps de retard fixe T entre les signaux m0 et m1 et un temps de transition tm. Le temps de transition tm est la durée présentée par le circuit de combinaison pour faire passer le signal Fk de sa valeur minimum à sa valeur de saturation lorsque K vaut 0 ou 1. D'autre part les figures montrent les variations du retard t_{K} en fonction du coefficient K pour différentes valeurs du temps de transition tm, le retard fixe T étant supposé fixé.

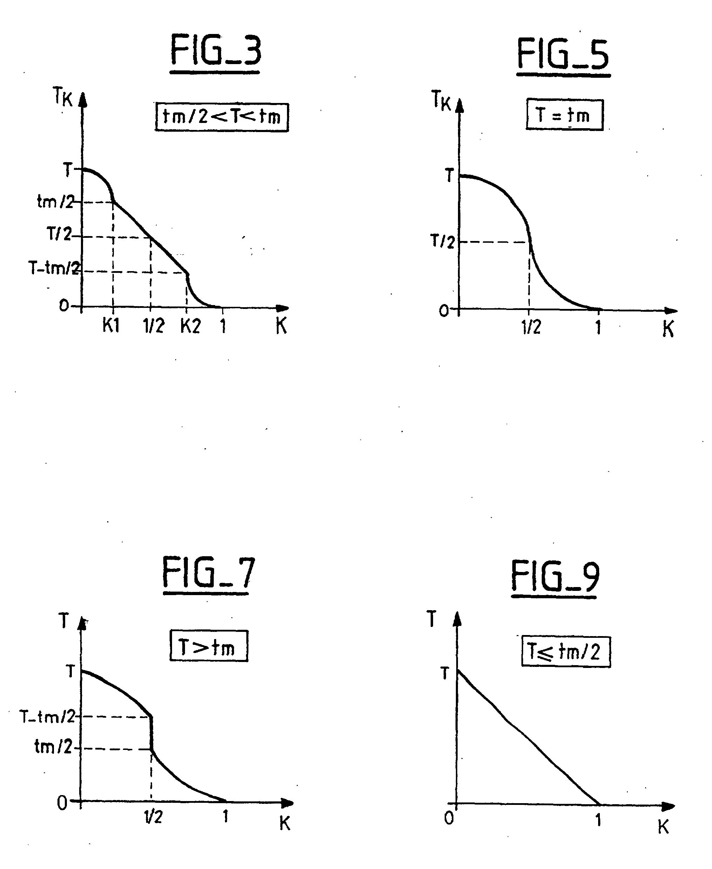

Le cas où T est compris entre tm/2 et tm est représenté figures 2 et 3.

Le chronogramme figure 2a représente les signaux m0 et m1 appliqués aux entrées X et Y du circuit de combinaison C. Le signal m0 étant un signal logique, il présente un front raide de transition entre un premier et un second niveau qui est suivi bien plus tard d'un autre front non-représenté rétablissant le signal à son premier niveau. Le front descendant représente la fin de l'impulsion du signal R0 qu'on cherche à retarder. La durée de cette impulsion est grande par rapport à T, 2T, 3T .... Le signal retardé m1 a été représenté comme un signal identique à m0 mais retardé d'un retard T défini par le circuit D1. En pratique, le front du signal m0 est exploité par le circuit de combinaison à l'instant où le signal m0 atteint une valeur de seuil S1 du circuit de combinaison C. En général, la valeur de seuil S1 correspond au niveau moyen entre les niveaux minimum et maximum du signal m0. Il en est de même pour le signal m1. Dans le cas ou la valeur de seuil est réglée au niveau moyen, ces signaux m0 et m1 pourraient avoir une forme différente de celle représentée. Le retard T est défini comme l'intervalle de temps séparant les instants où le signal m0 et le signal m1 atteignent la valeur de seuil.

Le chronogramme de la figure 2b représente le signal de combinaison f_{K} pour différentes valeurs du coefficient de pondération K. Bien entendu, la forme des signaux représentés est une représentation simplifiée des signaux qu'on peut obtenir avec des circuits réels. Il convient toutefois de noter que cette représentation n'est pas éloignée de la réalité. En particulier, on observera toujours un palier de saturation. Ceci est montré sur la courbe f1 (K = 1) à partir de t = tm et sur les autres courbes à partir de t = tm + T. L'intégrale d'une impulsion finit de toutes façons par être limitée aux valeurs du potentiel d'alimentation. Dans le circuit F de mise en forme le signal Fk est comparé à une valeur de seuil S2 de préférence au niveau moyen entre le maximum et le minimum de f_{K}. Au moment ou le comparateur bascule on produit le signal de sortie dont le retard par rapport au signal e0 a été recherché.

Le signal f1 correspond au cas où K est égal à 1, c'est-à-dire lorsque le coefficient de pondération appliqué au signal m1 est nul. Le signal a la forme d'un trapèze dont le front montant débute à l'instant zéro correspondant à l'instant où le signal m0 atteint une valeur de seuil S1. Le signal f1 augmente de façon linéaire, l'intégration d'une constante étant une fonction affine, jusqu'à l'instant tm où il atteint un palier de saturation.

Le signal f0 correspond au cas où le coefficient de pondération K appliqué au signal m0 est nul. Ce signal reproduit le signal f1 avec le retard T. Pour des coefficients de pondération différents de ces deux cas extrêmes, le signal de combinaison a l'allure représentée par les courbes f_{K1} et f_{K2}. La courbe représentative du signal de combinaison comporte alors trois parties distinctes Pa1, Pa2 et Pa3. La portion Pa1 correspond à l'intervalle de temps pendant lequel le signal m1 n'a pas encore atteint le seuil S1. Le signal fki est alors uniquement proportionnel au signal m0. La portion Pa3 de la courbe représentative de fki correspond à l'intervalle de temps à partir duquel le signal f1 arrive à saturation. Le signal fki est alors uniquement proportionnel au signal m1. La portion Pa2 correspond à l'intervalle de temps entre l'arrivée du signal m1 à sa valeur seuil et l'arrivée à saturation de f1. Les signaux f1 et f0 atteignent la valeur du seuil S2 respectivement aux instants t1 et t0 tandis que le signal f_{Ki} atteint ce seuil à un instant Θᵢ. L'écart entre t1 et t0 est égal au retard T. Ainsi, les retards respectivement minimum et maximum du signal de combinaison par rapport au signal d'entrée sont compris entre respectivement t1 et t0. Par conséquent, le retard obtenu dans le cas général aura une valeur Θ comprise entre t1 et t1 + T.

Le chronogramme de la figure 2c représente le signal de sortie du circuit de mise en forme F dans chacun des trois cas représentés sur le chronogramme de la figure 2b. Ainsi, les signaux S1 et S0 présentent un front respectivement aux instants t1 et t0. Pour un coefficient K donné, le signal de sortie s_{K} possédera un front retardé d'une valeur T_{K} par rapport aux signal S1, la valeur T_{K} étant comprise entre 0 et T, soit t1 + T par rapport à m0.

Sur la figure 3, on voit que pour K compris entre 0 et une première valeur K1, T_{K} varie entre T et tm/2 selon une sinusoïde. Cette première valeur K1 correspond au coefficient 1 - K facteur de m1, qui coïncide avec un retard Θ égal à tm. Pour K compris entre 0 et K1, la valeur Θ obtenue, caractéristique du retard, varie en effet comme le cosinus d'un angle α2 mesurant l'angle entre la portion Pa3 de la courbe f_{K} et l'horizontale. Le calcul permet de vérifier facilement que K1 est égal à 1 - tm/2T, par exemple en établissant une équation de la droite contenant la portion de courbe Pa3.

De même, pour K compris entre K2 et 1, la valeur Θ obtenue, caractéristique du retard, varie comme le cosinus de l'angle α1 mesurant l'angle entre la portion de courbe Pa1 et l'horizontale. De la même façon qu'on a calculé K1, on peut calculer K2 = tm/2T. Entre K1 et K2, la portion Pa2 de la courbe f_{K} est parallèle à f1 et f0; elle est en effet le résultat d'une combinaison linéaire de deux droites parallèles, les droites porteuses des courbes représentatives de f0 et f1. Donc pour K compris entre K1 et K2, les valeurs de retard Θ sont le résultat d'une fonction linéaire de K.

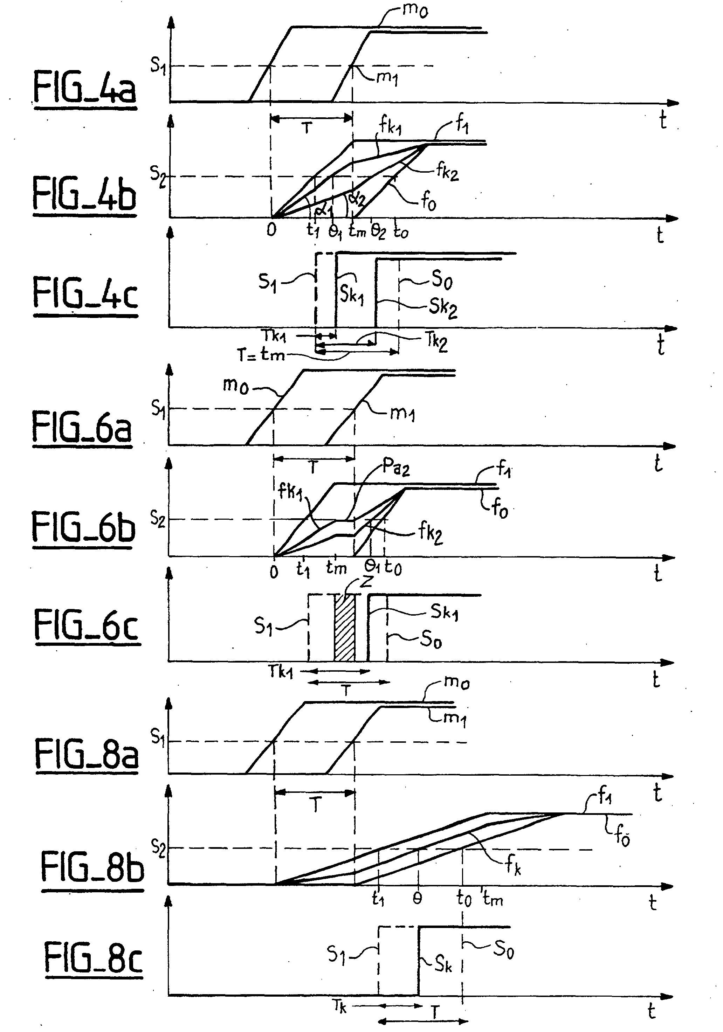

Les figures 4 et 5 représentent le cas où T égal tm. Dans ce cas, les valeurs K1 et K2 définies précédemment sont égales, et la portion linéaire du retard T_{K} en fonction de K a disparu. La fonction de retard T_{K}, admettant K comme variable, n'est alors jamais linéaire.

Les figures 6 et 7 représentent le cas où T est supérieur à tm. Dans ce cas, la portion Pa2 du signal f_{K} est horizontale, car elle est la combinaison linéaire de F₁ et F₀ qui sont, sur l'intervalle considéré horizontales. Si K est égal à 1/2, cette portion horizontale de f_{K} se situe alors au niveau du seuil de transition S2. Le retard n'est alors pas parfaitement défini, il est quelque part dans l'intervalle Z du chronogramme C de la figure 6, ce qui crée une discontinuité au niveau de la courbe T_{K} en fonction de K, représentée figure 7.

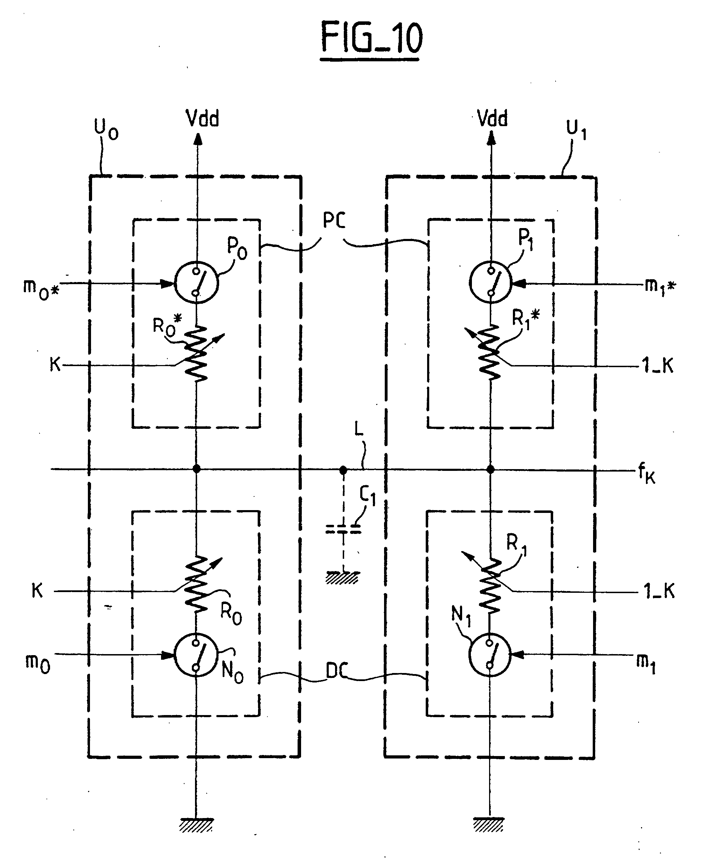

Les figures 8 et 9 représentent le cas où T est inférieur à tm/2. Dans ce cas, le seuil S2 ne peut être atteint qu'avec la portion Pa2 de la courbe fₖ, donc la réponse est nécessairement linéaire comme c'est visible sur la figure 9.

La façon dont le retard Θ varie en fonction du coefficient de pondération K dépend donc essentiellement du temps de transition tm défini ci-dessus et du retard fixe T. Le temps de transition tm définira le retard minimum t1 du signal de sortie s_{K} par rapport au signal d'entrée e0. Dans le cas parfaitement linéaire tel que celui considéré, ce retard minimum est égal à la moitié du temps de transition. Dans l'invention, pour résoudre le problème de durée du retard on a prévu plusieurs circuits de retard en série. Pour les retards existant entre les combinaisons de signaux e0 r1, r1 r2 et r2 r3, on choisira de préférence des valeurs T inférieures à tm. Cependant, ce n'est pas une obligation. On perdrait le cas échéant un peu de linéarité.

L'analyse précédente permet de tirer quelques conclusions concernant le dimensionnement à apporter au circuit primaire et au circuit de combinaison. Il apparaît tout d'abord que T doit de préférence être inférieur à tm pour éviter toute discontinuité du retard T_{K} en fonction du coefficient de pondération K, donc de la consigne de retard. D'autre part on obtient une réponse linéaire du retard T_{K} en fonction de K dès que T est inférieur ou égal à tm/2. Ainsi, pour tm fixé, on obtiendra une réponse linéaire tout en ayant la plus grande plage de réglage lorsque T est égal à tm/2.

Le retard fixe T détermine la plage de réglage du retard. Aussi, pour une plage déterminée, il sera toujours possible d'obtenir une réponse linéaire en choisissant tm = 2T. On pourra cependant être amené à choisir un temps de transition inférieur afin de réduire le retard minimal t1 qui dépend directement du temps de transition tm. D'une façon générale, le choix de T et de tm résultera d'un compromis entre le retard minimal, la plage de réglage et la linéarité du retard par rapport à la consigne de retard.

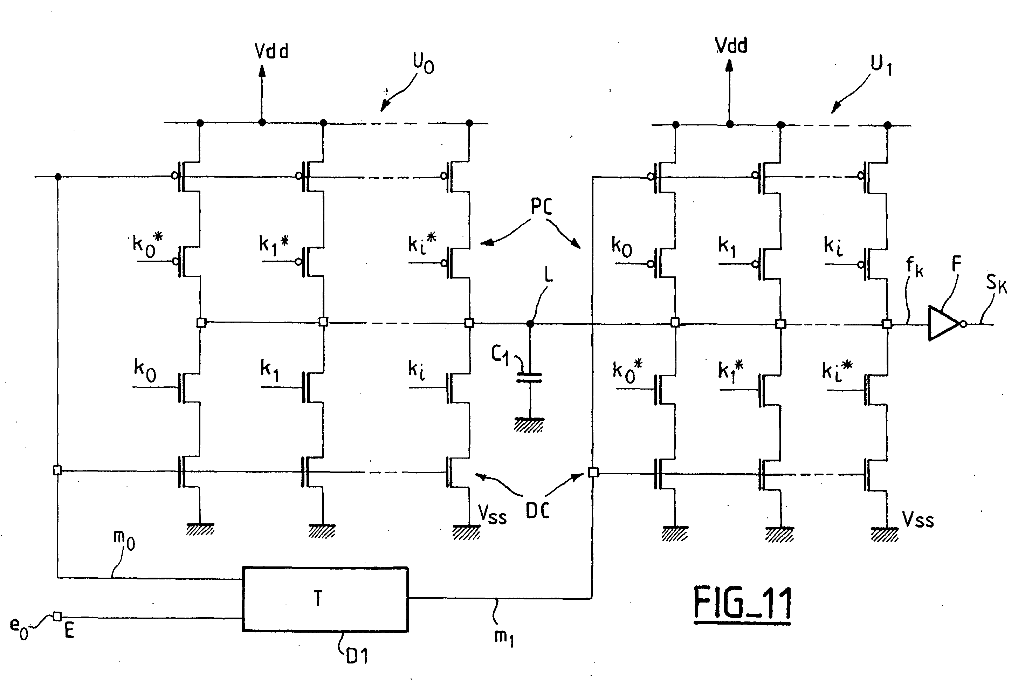

Les figures 10 et 11 concernent une réalisation schématique et en technologie CMOS du circuit de combinaison C.

La figure 10 est la représentation schématique d'une réalisation CMOS permettant de faciliter sa compréhension. Le circuit de la figure 10 comporte un premier et un second module de charge et décharge U0, U1, d'une ligne commune L. La ligne commune L est reliée à un condensateur C1. Le condensateur C1 est par ailleurs relié à la masse, ou a un autre potentiel constant. Ce dernier pourrait même être Vdd, le fonctionnement du circuit étant alors inversé. Le potentiel de la ligne commune constitue la mesure du signal de combinaison. Chaque module U0, U1 comporte un circuit de charge PC et un circuit de décharge DC. Chaque circuit de charge PC comporte une résistance variable R0* pour le module U0, R1* pour le module U1, et un interrupteur P0 pour U0, P1 pour U1. Chaque circuit de décharge DC comporte également une résistance variable R0 pour U0, R1 pour U1 et un interrupteur N0 pour U0 et N1 pour U1. Chaque interrupteur contrôle la connexion par la résistance qui lui est associée entre la ligne L et le potentiel d'alimentation Vdd pour le circuit de charge et Vss pour le circuit de décharge. Les interrupteurs des unités U0 et U1 sont commandés respectivement par les signaux m0 et m1 et leur complément m0* et m1*.

Les résistances variables R0, R0*, sont commandées de façon à prendre une valeur inversement proportionnelle au coefficient K, tandis que les résistances R1, R1* de l'unité U1 sont commandées de façon à prendre une valeur inversement proportionnelle à 1 - K. Le potentiel de la ligne L constitue la mesure du signal de combinaison f_{K}.

Pour expliquer le fonctionnement du circuit de la figure 10, nous supposerons qu'initialement la ligne L est chargée au potentiel Vdd et que les signaux m0 et m1 sont à zéro. Les interrupteurs P0 et P1 sont alors fermés tandis que les interrupteurs N0 et N1 sont ouverts. Lorsque le signal e0 devient actif, l'interrupteur N0 se ferme et l'interrupteur P0 s'ouvre. Le circuit présente alors une constante de temps définie par la capacité de structure au niveau de la ligne L et une résistance équivalente aux résistances R0 et R1* montées en parallèle. Comme R0 et R1* sont inversement proportionnelles à respectivement K et 1 - K, la constante de temps est indépendante de K. La ligne L va alors se décharger avec cette constante de temps depuis la valeur Vdd vers la valeur (1 - K) Vdd. La décharge se poursuit de cette façon jusqu'à l'instant où le signal m1 devient actif. Dès lors, l'interrupteur N1 se ferme et l'interrupteur P1 s'ouvre. La ligne L va alors continuer à se décharger vers zéro avec la même constante de temps que précédemment. Lorsque le signal m0 redevient inactif, l'interrupteur P0 se ferme et l'interrupteur N0 s'ouvre, ce qui établit un circuit de charge de la ligne L vers la tension K Vdd. Lorsque m1 redevient inactif, on se retrouve dans la situation initiale.

La figure 11 représente la réalisation CMOS détaillée correspondant au circuit de la figure 10. Elle est conforme à la figure 2 décrite dans le brevet français n° 2 690 022. Les circuits de charge PC et de décharge DC sont constitués de transistors MOS respectivement à canal P et N. Les résistances variables R0, ..., R1* sont réalisées au moyens de transistors MOS branchés en parallèle et commandées par les signaux K0, ..., Kᵢ, et leur complément K0*, ..., Kᵢ*. Les interrupteurs associés sont constitués par les chemins drain source des transistors MOS dont les grilles reçoivent le signal associé e0, e1. La capacité de structure définissant la constante de temps est due au capacité drain-grille des transistors MOS actifs reliés à la ligne L.

De par la conception du circuit, la capacité résultante reste constante, indépendamment de la valeur de K. D'autre part, les transistors MOS constituant les résistances variables de chaque circuit de charge ou de décharge, peuvent être dimensionnés de façon à ce que leur résistance varie selon une puissance de 2, selon les poids des signaux de commande K0, ..., Kᵢ, ..., K0*, ..., Kᵢ*. On retrouve sur la figure 11 le circuit de retard D1 connecté à e0 en entrée et qui délivre les signaux m0 et m1 ainsi que le circuit de mise en forme F assurant le passage de f_{K} à Sₖ.

Quand m0 est à 1, ce sont les transistors du bas de la figure qui conduisent. On décharge donc la capacité C1. Quand m0 est à 0, ce sont les transistors du haut qui conduisent. La capacité C1 se charge alors.

Quand les commandes du module U0 sont validées, c'est-à-dire quand tous les kᵢ sont à 1, et que m0 est à 0, on charge la capacité C1 avec un retard minimum. On peut ensuite faire passer les kᵢ à 0 au moment du réglage ou de la programmation. On ne modifie plus les valeurs de kᵢ lorsque le retard à imposer est déterminé. On active ainsi, petit à petit en fonction des besoins, des branches du module U1. La capacité C1 se charge toujours, mais avec un certain retard. Enfin, quand toutes les commandes kᵢ, sont à 0, le courant passe uniquement par le module U1 et le retard est alors maximal pour la charge de la capacité C1.

La phase de décharge du condensateur suit le principe décrit ci-dessus pour la charge, avec m0 et donc a fortiori m1 égaux à 1.

On peut ainsi obtenir un retard pour la montée (passage de 0 à 1) et pour la descente (passage de 1 à 0) des signaux m0 et m1. Afin d'assurer la linéarité du retard, il faut que la capacité ait été chargée à Vdd. Il a donc préalablement fallu que l'impulsion soit assez longue, afin de charger totalement Vdd. Avec une impulsion e0 de niveau haut 5 ns qui correspond à une fréquence de 100 MHz, ceci ne pose pas de problème.

Le potentiel du condensateur C1, que l'on retrouve au noeud L, est le potentiel du signal S_{K}. Ce n'est que lorsque ce potentiel atteint le seuil du circuit de mise en forme F que le signal S_{K} bascule.

On obtient, à l'aide du schéma de la figure 11, une plage de retard déterminée uniquement par le retard entre les signaux m0 et m1. Or, d'un point de vue technologique, on a désormais besoin de plages de retard plus importantes. C'est pourquoi on a prévu le système avec multiplexeur de la figure 1.

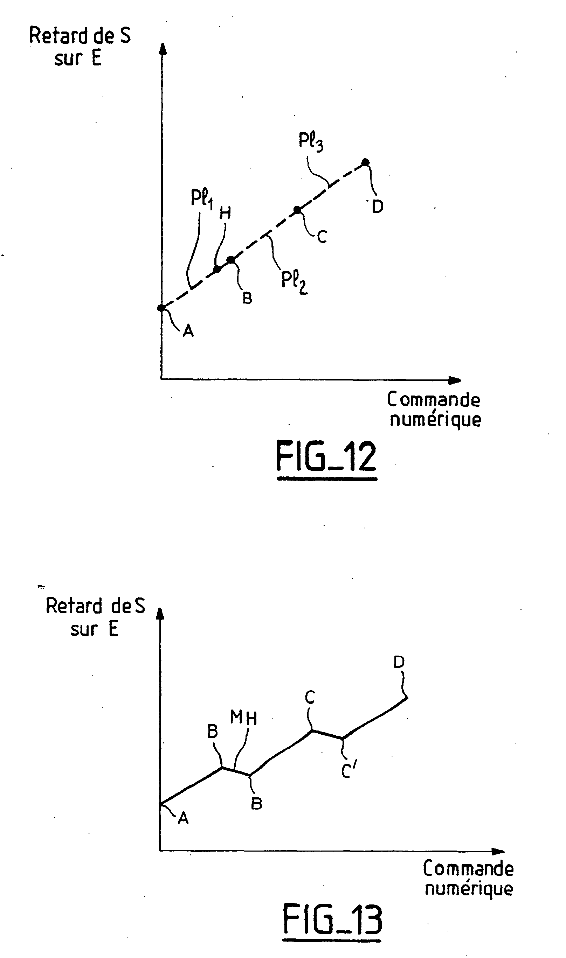

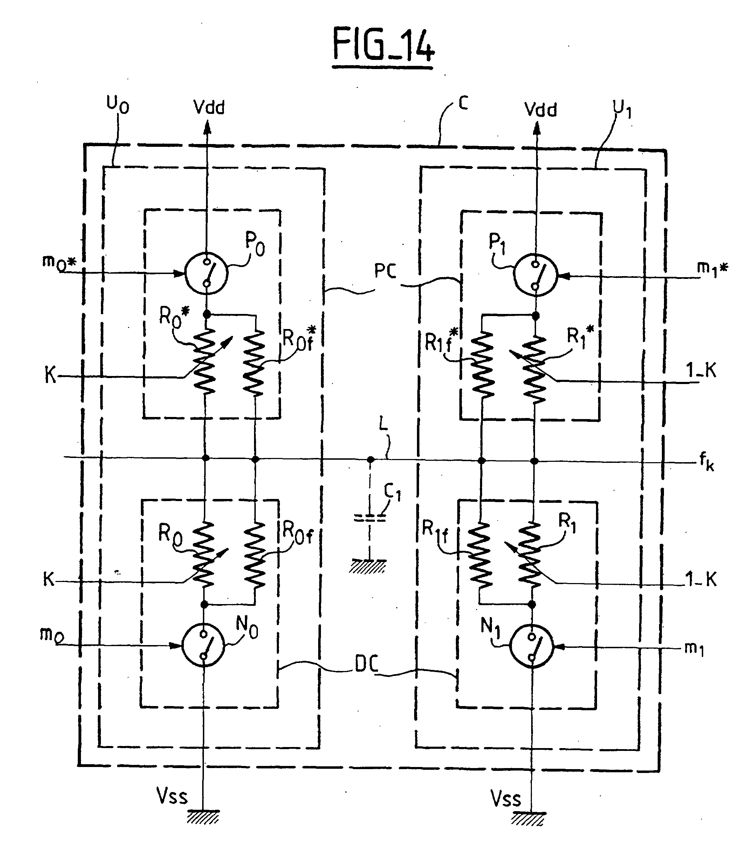

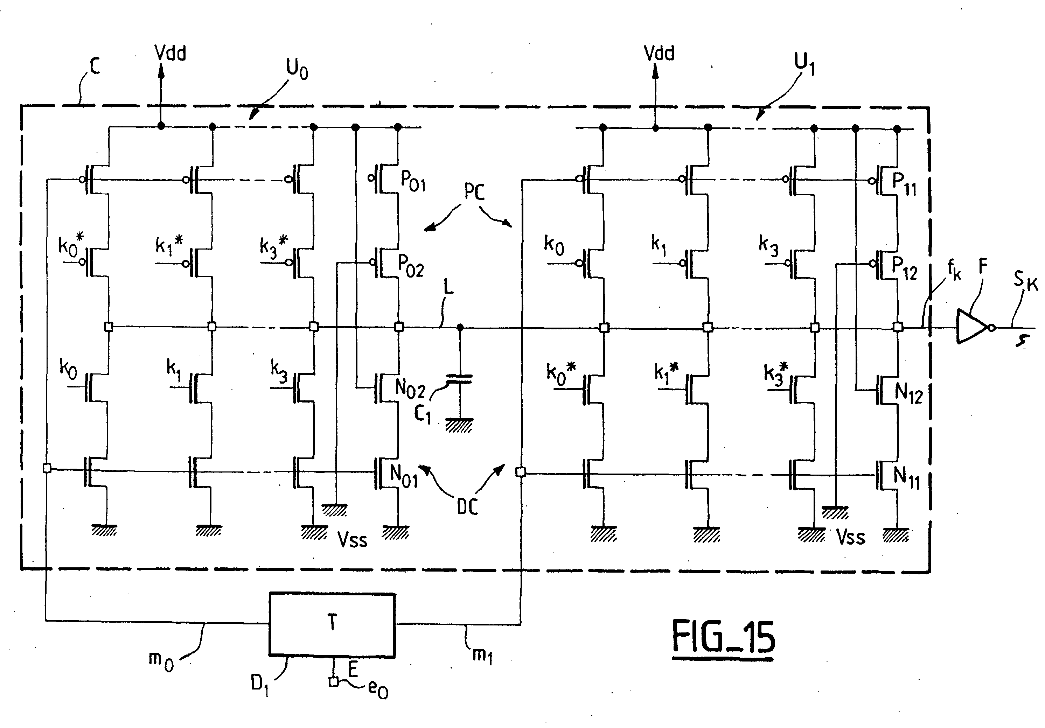

Cette solution n'est toutefois pas toujours satisfaisante comme on va l'expliquer au regard des figures 12 et 13. Elle a été perfectionnée dans la présente invention par les circuits montrés figures 14 et 15.

La figure 12 montre une courbe représentant le retard entre l'entrée E et la sortie S du circuit de la figure 11 en fonction du signal de commande numérique. Cinq points caractéristiques sont visibles sur la courbe. Le point a correspond au retard minimal, donc au cas où ce sont les signaux e0 et r1 qui entrent dans le circuit de combinaison, avec 100% du courant qui passe dans le module U0. Le point b correspond au retard maximal quand e0 et r1 entrent dans le circuit de combinaison avec 100% du courant qui passe dans le module U1. Le segment compris entre a et b constitue la plage P11. Lorsque le retard à provoquer est plus grand que celui du point b, on commute le multiplexeur MUX0 seul. On peut atteindre alors une deuxième plage Pl2 de retard. Cette deuxième plage Pl2 s'achève par un point c qui correspond au retard maximal entre r1 et r2 avec 100% du courant passant par le module U0. L'avantage du mode de connexion préconisé permet en effet de ne commuter qu'un multiplexeur (MUX0) en tenant compte du caractère symétrique du circuit des figures 11 et 15. Puis c'est au tour du multiplexeur MUX1 de basculer, le signal r1 laissant sa place au signal r3. On peut ainsi entamer une troisième plage Pl3 de la courbe de retard et l'on arrive au point d qui correspond à un retard maximal entre r2 et r3 avec 100% du courant qui passe par le module U1. Si l'on considère le point H situé sur la première plage de la courbe de retard, on peut dire qu'en ce point, approximativement 90% du courant passe par le module U0 et 10% passe par le module U1.

Cette courbe demeure cependant théorique. Dans la pratique, c'est la courbe représentée figure 13 que l'on obtient. On observe sur cette courbe lorsque les multiplexeurs basculent, une non-linéarité de la courbe de retard en fonction de la commande numérique qui se traduit par un méplat MH horizontal ou pis encore, incliné vers le bas. La position des points X et X', X et X' étant deux termes génériques désignant respectivement le dernier point d'une plage et le premier de' la plage suivante, ne permettent pas d'obtenir une courbe linéaire. Elle n'est d'ailleurs même plus monotone car les méplats MH joignant les points X et X' sont descendants. Ce type de problème peut s'expliquer par des fuites de courant, des réinjections de charge de la sortie sur l'entrée, ou par des problèmes de répartition de charge au niveau de la capacité C1.

Les figures 14 et 15 présentent selon l'invention une solution à ce problème.

La figure 14 reprend le circuit de la figure 10. On y retrouve les deux modules U0 et U1 qui constituent le circuit de combinaison C. On y a ajouté quatre résistances non variables R0f, R0f*, R1f et R1f* connectées en parallèle respectivement à R0, R0*, R1 et R1*. Ces résistances non variables ne dépendent plus de K. Elles assurent que chaque module U0 et U1 contribue en permanence à la charge ou la décharge de la ligne L. L'intérêt d'un tel montage sera précisé avec l'étude de la figure 15 qui propose une description plus détaillée de ce circuit.

La figure 15 reprend le circuit de la figure 11. Les multiplexeurs MUX0 et MUX1 et les mémoires tampons T1, T2 et T3 constituent le circuit de retard D1. Sur chacun des deux modules U0 et U1 qui constituent le circuit de combinaison C, on a ajouté une branche en parallèle. Ces branches comportent chacune en série deux transistors à canal P en série et deux transistors à canal N en série. Les transistors à canal P P01 et P02 pour U0, P11 et P12 pour U1, interviennent de la même façon que les transistors à canal P déjà présents dans le circuit représenté sur la figure 11 dans les circuits de charge de U0 et U1. Les nouveaux transistors à canal N, N01 et N02 pour U0, N11 et N12 pour U1, interviennent de façon similaire dans les circuits de décharge de U0 et U1. Les transistors ajoutés P01, N01, P11 et N11 qui jouent le rôle d'interrupteurs sont toujours connectés aux signaux m0 et m1. Mais ceux qui servent de résistances variables, à savoir P02, N02, P12 et N12, sont alimentés en permanence: les transistors ajoutés à canal N, N02 et N12, sont reliés au potentiel Vdd et les transistors ajoutés à canal P, P02 et P12 sont reliés au potentiel Vss. Ils ne dépendent pas d'une commande K ou K*. Aussi, les branches supplémentaires conduiront toujours. Ceci compense les fuites et les problèmes de répartition de charge observables lors de la commutation des multiplexeurs, qui se traduisent par un méplat horizontal ou légèrement décroissant. Les répartitions des courants dans les modules U0 et U1 s'en trouvent légèrement modifiées: on ne pourra désormais plus avoir 100% du courant passant dans une module et 0% dans l'autre.

Dans la réalisation pratique, chaque module comporte typiquement trois transistors commandés par les commandes K et K*. Le transistor ajouté qui est relié en permanence au potentiel Vdd ou Vss sera typiquement plus petit que les trois autres transistors, de façon à ce qu'on ait au maximum 90% du courant qui puisse passer par un module U0 ou U1. Ceci signifie que le transistor alimenté en permanence doit être trois fois plus petit que les autres transistors.

Dans une autre application courante, les transistors commandés par les coefficients K0, K1, etc... ont des largeurs de grille en progression binaire (1, 2, 4, etc...). Le transistor ajouté dans la branche supplémentaire a une largeur de grille moitié de la plus petite des largeurs de grille précédentes. On pourrait imaginer une autre implémentation dans laquelle on aurait sept branches identiques. Dans ce cas, la branche ajoutée a une largeur de grille moitié de celle des autres branches.

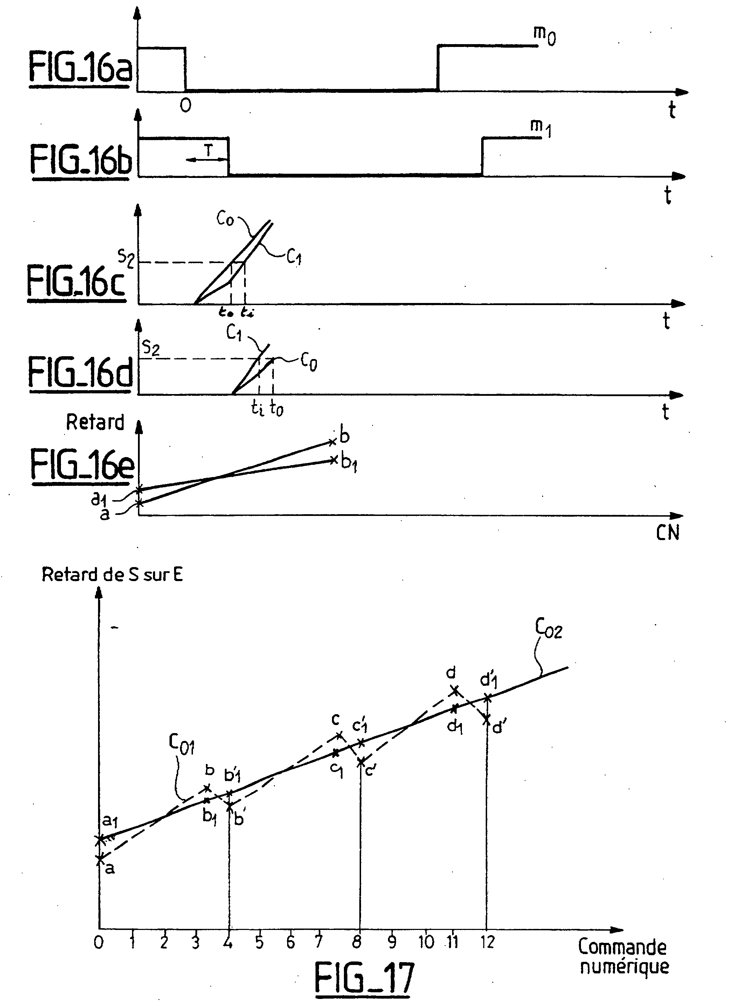

Les figures 16a, 16b, 16c, 16d et 16e permettent d'expliquer ce qui se passe à présent sur la première plage. Dans leur description, il sera souvent fait référence au circuit de la figure 15.

Les figures 16a et 16b sont les chronogrammes des signaux m0 et m1 décalés d'un temps T. L'origine des temps est définie lorsque m0 bascule à 0.

Supposons tous les coefficients ki à 1. Ceci correspond à K = 1, et à un retard minimum égal à t1 (voir figures 2b, 4b, 6b, 8b). On est alors au début d'une plage, le courant passant essentiellement par le module recevant le signal le moins retardé. Pour un intervalle de temps compris entre 0 et T, tous les transistors à canal P de la figure 15 commandés par les coefficients k* conduisent et contribuent à la charge du condensateur C1. Cependant, m1 valant 1, le transistor à canal N N12 de la figure 15 contribue à la décharge de C1, ce qui ne se produisait pas en l'absence des transistors ajoutés par l'invention. Aussi, la valeur de seuil S2 définie précédemment sera atteinte plus tard. Ceci est illustré par la figure 16c. Les courbes Co et Ci correspondent respectivement à la charge du condensateur C1 avant et après l'introduction des transistors connectés en permanence. Les temps to et ti sont respectivement les temps mis, avant et après le perfectionnement de l'invention, par le signal Sk pour atteindre la valeur seuil S2. On a donc en début de plage un retard ti plus important que to. On peut remarquer sur la figure 16c qu'une fois que m1 a basculé à 0, la charge du condensateur C1 est plus rapide qu'auparavant. Ceci s'explique par le fait que P11 participe alors à la charge de C1.

Supposons à présent tous les ki égaux à 0. Ceci correspond à K = 0 et à un retard maximal égal à t0 (voir figures 2b, 4b, 6b, 8b). On se situe alors en fin de plage. Le courant passe essentiellement par le module recevant le signal le plus retardé. Pour un intervalle de temps compris entre 0 et T, pour le module U0, seul le transistor P02 contribue à la charge du condensateur C1, mais m1 étant à 1, tous les transistors à canal N du module U1 favorise la décharge de C1. Le condensateur ne se charge donc pas. Au-delà de cet intervalle, m1 est à 0 et tous les transistors à canal P du module U1 contribuent à la charge de C1, ainsi que P02. La charge du condensateur C1 est donc plus rapide que lorsque P02 n'était pas présent dans le circuit. On a donc en fin de plage un retard tj moins important que t0.

Un raisonnement similaire peut être effectué pour le passage d'un niveau bas à un niveau haut et pour la décharge du condensateur. Dans tous les cas, le nouveau retard en début de plage est plus important que celui en absence des branches connectées en permanence, et il est moins important en fin de plage.

On obtient donc sur une plage la courbe représentée figure 16e. Les points S1 et B1 sont ceux de la nouvelle courbe de retard. Le point S1 et B1 sont respectivement au dessus et en dessous des points A et B précédent (figure 12).

La figure 17 explique le changement de plage. Elle montre en tirets la courbe réelle des retards provoqués sans le perfectionnement, a b b' c c' d d' qui est une ligne brisée. La courbe des retards obtenue avec le perfectionnement de l'invention est montrée en trait plein. Cette dernière passe par les points a1 b1 b'1 c1 c'1 dl d'1 qui sont tous alignés. Le retard associé au point b1 est bien inférieur à celui associé au point b alors que le retard associé au point b'1 est supérieur à celui associé au point b'.

Au moment du basculement d'un multiplexeur (MUX0 ou MUX1), on débute une nouvelle plage. Le premier retard de la nouvelle plage est supérieur, avec le circuit de la figure 15 à celui obtenu avec le circuit de la figure 11. L'avantage d'un tel montage est que, même au moment de la commutation des multiplexeurs, le retard sera forcement augmenté. l'addition des différences t0-tj de la plage "basse" et ti-t1 de la plage haute sont ensemble supérieures aux dérives ab' ou cc' de la figure 13.

La commande numérique pourra donc commander plus efficacement les valeurs des coefficients ki et le basculement des multiplexeurs. En effet, si cette commande résulte d'une action asservie, le fait que l'asservissement possède une pente négative (b b', c c') et en particulier un sommet, en b ou en c, de la courbe de gain, conduit cet asservissement à osciller autour de la valeur associée au point b.

La figure 17 montre également la comparaison entre les courbes de retard obtenues: la courbe Co1 représentative du temps de retard en l'absence des branches connectées en permanence, et la courbe Co2 caractéristique du temps de retard pour le circuit comprenant les branches connectées en permanence. On voit sur la courbe Co2 qu'on se rapproche d'une linéarité optimale; le retard est ainsi de toute façon toujours augmenté.

## Revendications

1. Circuit à retard pour fournir un signal de sortie (s_{K}) présentant un retard (Θ) par rapport à un signal d'entrée (e0), le retard (Θ) étant réglable en fonction d'une consigne de retard (CN), le circuit à retard comportant
- un circuit primaire (D1), recevant le signal d'entrée (e0) et fournissant des premier et second signaux intermédiaires (m0, m1) présentant entre eux un retard fixe (T),
- un circuit de combinaison (C) à deux entrées (X, Y), les signaux intermédiaires (m0, m1) étant appliqués aux entrées (X, Y), fournissant en sortie un signal de combinaison (f_{K}) résultant d'une superposition avec une pondération fonction de la grandeur de commande (K) et un effet d'intégration des signaux appliqués sur ses entrées (X, Y),
- un circuit de mise en forme recevant le signal de combinaison, fournissant le signal de sortie S_{K}, et présentant un effet de seuil,
le circuit de combinaison comportant
- une entrée de commande (CD) recevant une grandeur de commande (K) représentative de la consigne (CN),
- une ligne commune (L) avec un condensateur (C1) relié à cette ligne commune et à un potentiel d'alimentation,
- un premier et un second module de charge et décharge (U0, U1) de la ligne commune (L) commandés respectivement par les premier et second signaux intermédiaires (m0, m1), le potentiel de la ligne commune (L) constituant la mesure du signal de combinaison (f_{K}),
le circuit à retard étant **caractérisé en ce que** chaque module (U0, U1) comporte un circuit de décharge (DC) et un circuit de charge (PC) comportant chacun des moyens interrupteurs (P0, N0, P1, N1) contrôlant la connexion entre la ligne commune (L) et respectivement un premier et un second potentiel d'alimentation (Vss, Vdd) d'une part par l'intermédiaire d'une résistance variable (R0, RO*, R1, R1*), d'autre part par une résistance non variable (R0f, R0f*, R1f, R1f*) assurant la participation permanente des deux modules (U0 et U1) à la charge ou la décharge du condensateur (C1) et **en ce que** les moyens interrupteurs (P0, N0, P1, N1) du circuit de décharge (DC) et du circuit de charge (PC) de chaque module (U0, U1) sont activés par les signaux intermédiaires (m0, m1).

2. Circuit à retard selon la revendication 1, **caractérisé en ce que** le retard fixe (T) est inférieur à un temps de transition (tm) que présente le signal de combinaison (f_{K}) lorsque le circuit de combinaison (C) reçoit seulement un des deux signaux (m0, m1).

3. Circuit selon l'une des revendications 1 ou 2, **caractérisé en ce que** la pondération consiste à pondérer par un coefficient de pondération chacun des signaux en entrée du circuit de combinaison (C), les valeurs des coefficients de pondération étant fonction de la grandeur de commande (K), la somme des deux coefficients de pondération étant constante, la résistance variable (R0, R0*, R1, R1*) des circuits de décharge et de charge (DC, PC) de chaque module (U0, U1) étant commandée de façon à prendre une valeur inversement proportionnelle au coefficient de pondération d'un des signaux intermédiaires (m0, m1).

4. Circuit à retard selon une des revendications 1 à 3, **caractérisé en ce que** les résistances variables (R0, RO*, R1, R1*) de chaque module (U0, U1) sont réalisées au moyen d'un ensemble de résistances élémentaires pouvant être branchées sélectivement en parallèle en fonction du coefficient de pondération du signal intermédiaire associé (m0, m1) audit module (U0, U1).

5. Circuit à retard selon l'une des revendications 1 à 4, **caractérisé en ce que** les résistances variables (R0, R0*, R1, R1*), les résistances non variables (R0f, R0f*, R1f, R1f*) et les interrupteurs (P0, N0, P1, N1) sont formés par les chemins drain-source de transistors MOS dont les grilles sont commandées en fonction des coefficients de pondération, par les signaux associés (m0, m1) ou par des potentiels constants.

6. Circuit à retard selon l'une des revendications 1 à 5, **caractérisé en ce qu'**un module de charge et de décharge comporte trois branches commandées par un signal de pondération (K) et une branche en conduction permanente.

7. Circuit à retard selon l'une des revendications 1 à 6, **caractérisé en ce que** le circuit à retard le circuit primaire (D1) est réalisé au moyen d'un jeu de mémoires tampons (Tl, T2, T3) en série, retardant pour chacune le signal à sa sortie d'un retard (T), à la sortie desquelles on obtient au moins des premier et deuxième signaux retardés (r1, r2), le signal d'entrée (e0) et les signaux retardés (r1, r2) étant appliqués aux entrées d'un premier et d'un deuxième multiplexeur (MUX0, MUX1) qui fournissent les premier et deuxième signaux intermédiaires (m0, m1).

## Patentansprüche

1. Verzögerungsschaltung zum Bereitstellen eines Ausgangssignals (s_{K}, welches in Bezug auf ein Eingangssignal (e0) eine Verzögerung (θ) aufweist, wobei die Verzögerung (θ) in Abhängigkeit von einer Verzögerungsanweisung (CN) steuerbar ist, wobei die Verzögerungsschaltung aufweist:
- einen Primärkreis (D1), der das Eingangssignal (e0) empfängt und ein erstes und zweites Zwischensignal (m0, m1) bereitstellt, die untereinander eine feste Verzögerung (T) aufweisen,
- eine Kombinationsschaltung (C) mit zwei Eingängen (X, Y), wobei die Zwischensignale (m0, m1) an die Eingänge (X, Y) angelegt werden, wobei beim Ausgang ein Kombinationssignal (f_{K}) bereitgestellt wird, das resultiert aus einer Überlagerung mit einer Gewichtsfunktion der Steuergröße (K) und einer Integrationswirkung der an deren Eingänge (X, Y) angelegten Signale,
- eine Aufbereitungsschaltung, die das Kombinationssignal empfängt, wobei das Ausgangssignal s_{K} bereitgestellt wird, und einen Schwelleneffekt aufweist,
wobei die Kombinationsschaltung aufweist,
- einen Steuereingang (CD), welcher eine für die Anweisung (CN) repräsentative Steuergröße (K) empfängt,
- eine gemeinsame Leitung (L) mit einem Kondensator (C1), der mit dieser gemeinsamen Leitung und einem Versorgungspotential verbunden ist,
- ein erstes und ein zweites Ladungs- und Entladungsmodul (U0, U1) der gemeinsamen Leitung (L), welche durch das erste beziehungsweise zweite Zwischensignal (m0, m1) gesteuert werden, wobei das Potential der gemeinsamen Leitung (L) die Erfassung des Kombinationssignals (f_{K}) bildet,
wobei die Verzögerungsschaltung **dadurch gekennzeichnet ist, dass** jedes Modul (U0, U1) eine Entladungsschaltung (DC) und eine Ladungsschaltung (PC) aufweist, welche jeweils Schaltermittel (P0, N0, P1, N1) aufweisen, welche die Verbindung zwischen der gemeinsamen Leitung (L) und einem ersten beziehungsweise zweiten Versorgungspotential (Vss, Vdd) einesteils durch Vermittlung eines variablen Widerstands (R0, R0*, R1, R1*), anderenteils durch einen nicht-variablen Widerstand (R0f, R0f*, R1f, R1f*). steuern, der die permanente Teilnahme der zwei Module (U0 und U1) an der Ladung oder Entladung des Kondensators (C1) sicherstellt und dadurch dass die Schaltermittel (P0, N0, P1, N1) der Entladungsschaltung (DC) und der Ladungsschaltung (PC) von jedem Modul (U0, U1) durch die Zwischensignale (m0, m1) aktiviert werden.

2. Verzögerungsschaltung nach Anspruch 1, **dadurch gekennzeichnet, dass** die feste Verzögerung (T) weniger als eine Übergangszeit (tm) beträgt, die das Kombinationssignal (fk) bereitstellt, wenn die Kombinationsschaltung (C) lediglich eines der beiden Signale (m0, m1) empfängt.

3. Schaltung nach einem der Ansprüche 1 oder 2, **dadurch gekennzeichnet, dass** die Gewichtung darin besteht mit einem Gewichtskoeffizienten jedes der Signale beim Eintritt in die Kombinationsschaltung (C) zu gewichten, wobei die Werte der Gewichtskoeffizienten in Abhängigkeit von der Steuergröße (K) sind, wobei die Summe der zwei Gewichtskoeffizienten konstant ist, wobei der variable Widerstand (R0, R0*, R1, R1*) der Entladungs- und Ladungsschaltungen (DC, PC) von jedem Modul (U0, U1) derart gesteuert ist, einen zum Gewichtskoeffizienten von einem der Zwischensignale (m0, m1) invers proportionalen Wert anzunehmen.

4. Verzögerungsschaltung nach einem der Ansprüche 1 bis 3, **dadurch gekennzeichnet, dass** die variablen Widerstände (R0, R0*, R1, R1*) von jedem Modul (U0, U1) mittels einer Anordnung von Elementarwiderständen verwirklicht sind, die selektiv in Abhängigkeit von dem Gewichtskoeffizienten des assoziierten Zwischensignals (m0, m1) an dem Modul (U0, U1) parallelgeschaltet werden können.

5. Verzögerungsschaltung nach einem der Ansprüche 1 bis 4, **dadurch gekennzeichnet, dass** die variablen Widerstände (R0, R0*, R1, R1*), die nicht-variablen Widerstände (R0f, R0f*, R1f, R1f*) und die Schalter (P0, N0, P1, N1) durch die Wege Drain-Source von MOS-Transistoren gebildet sind, deren Gates in Abhängigkeit von Gewichtskoeffizienten durch die assoziierten Signale (m0, m1) oder durch konstante Potentiale gesteuert sind.

6. Verzögerungssehaltung nach einem der Ansprüche 1 bis 5, **dadurch gekennzeichnet, dass** ein Ladungs- und Entladungsmodul drei Zweige aufweist, die durch ein Gewichtssignal (K) und einen Zweig unter dauernder Leitung gesteuert sind.

7. Verzögerungsschaltung nach einem der Ansprüche 1 bis 6, **dadurch gekennzeichnet, dass** in der Verzögerungsschaltung die Primärschaltung (D1) mittels eines Satzes serieller Pufferspeicher (T1, T2, T3) verwirklicht ist, wobei für jeden das Signal bei dessen Ausgang um eine Verzögerung (T) verzögert wird, wobei man am Ausgang von ihnen mindestens ein erstes und zweites verzögertes Signal (r1, r2) erhält, wobei das Eingangssignal (e0) und die verzögerten Signale (r1, r2) an Eingänge eines ersten und einesizweiten Multiplexers (MUX0, MUX1) angelegt sind, welche das erste und zweite Zwischensignal (m0, m1) bereitstellen.

## Claims

1. Delay circuit to produce an output signal (s_{K}) having a delay (θ) relative to an input signal (e0), the delay (θ) being adjustable as a function of a desired value of delay (CN), the delay circuit comprising
- a primary circuit (D1) which receives the input signal (e0) and produces first and second intermediate signals (m0, m1) having a fixed delay (T) between them,
- a combining circuit (C) having two inputs (X, Y), the intermediate signals (m0, m1) being applied to the inputs (X, Y), said combining circuit (C) producing at its output a combination signal (f_{K}) which is the result of superimposition of a weighting which is a function of the controlling magnitude (K) and an integrating action on the signals applied to its inputs (X, Y),
- a shaping circuit which receives the combination signal, produces the output signal S_{K}, and has a threshold action, the combining circuit comprising
- a control circuit (CD) which receives a controlling magnitude (K) representative of the desired value (CN)
- a common line (L) having a capacitor (C1) which is connected to said common line and to a supply potential,
- a first and a second module (U0, U1) for charging and discharging the common line (L), which modules (U0, U1) are controlled by respective ones of the first and second intermediate signals (m0, m1), the potential on the common line (L) forming a measurement of the combination signal (f_{K}),
the delay circuit being **characterised in that** each module (U0, U1) has a discharge circuit (DC) and a charging circuit (PC) each comprising breaking-switch means (P0, N0, P1, N1) controlling the connection between the common line (L) and respective ones of first and second supply potentials (Vss, Vdd), said connection running on the one hand via a variable resistor (R0, R0*, R1, R1*) and on the other via a non-variable resistor (R0f, R0f*, R1f, R1f*) which ensure that the two modules (U0 and U1) take part at all times in the charging or discharge of the capacitor (C1), and **in that** the breaking-switch means (P0, N0, P1, N1) in the discharge circuit (DC) and charging circuit (PC) belonging to each module (U0, U1) are activated by the intermediate signals (m0, m1).

2. Delay circuit according to claim 1, **characterised in that** the fixed delay (T) is shorter than a transition time (tm) which the combination signal (f_{K}) has when the combining circuit (C) receives only one of the two signals (m0, m1).

3. Circuit according to either of claims 1 and 2, **characterised in that** the weighting comprises weighting each of the input signals to the combining circuit (C) by a weighting coefficient, the values of the weighting coefficients being a function of the controlling magnitude (K) and the sum of the two weighting coefficients being constant, the variable resistors (R0, R0*, R1, R1*) in the discharge and charging circuits (DC, PC) in each module (U0, U1) being controlled to assume a value which is inversely proportional to the weighting coefficient of one of the intermediate signals (m0, m1).

4. Delay circuit according to one of claims 1 to 3, **characterised in that** the variable resistors (R0, R0*, R1, R1*) in each module (U0, U1) are implemented by means of a set of unitary resistors which can be connected selectively in parallel as a function of the weighting coefficient of the intermediate signal (m0, m1) associated with said module (U0, U1).

5. Delay circuit according to one of claims 1 to 4, **characterised in that** the variable resistors (R0, R0*, R1, R1*), the non-variable resistors (R0f R0f*, R1f, R1f*) and the breaking switches (P0, N0, P1, N1) are formed by the drain-source paths of MOS resistors whose gates are controlled, as a function of the weighting coefficients, by the associated signals (m0, m1) or by constant potentials.

6. Delay circuit according to one of claims 1 to 5, **characterised in that** a charging module and a discharge module have three paths which are controlled by a weighting signal (K) and a path which is permanently conductive.

7. Delay circuit according to one of claims 1 to 6, **characterised in that**, (in the)¹ delay circuit, the primary circuit (D1) is implemented by means of a set of buffer stores (T1, T2, T3) in series, each of which delays the signal at its output by a delay (T), at the outputs of which buffer stores (T1, T2, T3) are obtained at least first and second delayed signals (r1, r2), the input signal (e0) and the delayed signals (r1, r2) being applied to the inputs of first and second multiplexers (MUX0, MUX1) which produce the first and second intermediate signals (m0, m1)
